# FASCICULE DE BREVET EUROPEEN

(11) **EP 2 745 663 B1**
(45) Date de publication et mention de la délivrance du brevet: **14.09.2016**
(21) Numéro de dépôt: 12758572.7
(22) Date de dépôt: 20.08.2012
(51) Int. Cl.: H05K 7/20, H05K 7/14

(54) **INFRASTRUCTURE TECHNIQUE DE CENTRE DE DONNEES**
TECHNISCHE INFRASTRUKTUR FÜR EIN DATENZENTRUM
TECHNICAL INFRASTRUCTURE FOR A DATA CENTRE

(30) Priorité: 19.08.2011 FR 1157424
(43) Date de publication de la demande: 25.06.2014
(73) Titulaire: OVH SAS, 59100 Roubaix (FR)
(72) Inventeur: KLABA, Henryk, F-59100 Roubaix (FR)
(74) Mandataire: Louiset, Raphaël
(86) Numéro de dépôt international: PCT/FR2012/051913
(87) Numéro de publication internationale: WO 2013/026985

(56) Documents cités:
- EP-A1- 2 354 378
- US-A1- 2009 229 194
- US-A1- 2009 251 860
- US-A1- 2010 251 629
- US-B1- 7 278 273

## Description

La présente invention concerne l'architecture des infrastructures techniques, et plus particulièrement l'optimisation énergétique de celles-ci.

On entend, ici, par « infrastructure technique » toute infrastructure immobilière dédiée aux technologies de l'information et de la communication tel qu'un centre de calcul/centre de données (data center), un centre d'hébergement, un centre de repli (back-up site), ou un hôtel de télécommunication (telecom/carrier hotel, ou server-farm).

Ces infrastructures prennent généralement la forme de grandes salles (ou bâtiments) informatiques comprenant, à titre d'exemples non-exhaustifs, des équipements de télécommunications, des serveurs, des systèmes de stockage, des systèmes d'alimentation, des systèmes de refroidissement, des onduleurs, des systèmes de distribution électrique, et des postes de travail.

Afin de maintenir l'hygrométrie et la température dans des plages préconisées au sein de ces infrastructures, des systèmes et méthodes de refroidissement y sont agencés.

Cependant, avec le déploiement accéléré de nouveaux usages (multimédia, Internet des objets, Cloud Computing par exemple), ces infrastructures logent de plus en plus d'équipements énergivores qui ont pour effets de pousser les systèmes de refroidissement aux limites de leurs capacités et que, par conséquent, l'efficacité énergétique de ces infrastructures se voyant réduite.

Les architectures connues des infrastructures techniques viennent encore altérer l'efficacité énergétique de ces dernières. En effet, ces infrastructures sont généralement agencées en forme de bâtiments conçus pour conserver la chaleur, et non pas la dissiper.

L'empilement d'étages d'équipement informatiques sans aucune considération de la morphologie globale de l'infrastructure, entraine une surconsommation d'énergie, notamment, par les systèmes de refroidissement et de gestion de l'air.

Un objet de la présente invention est de fournir une technique palliant les inconvénients de l'art antérieur.

Un autre objet de la présente invention est de proposer une architecture (un agencement) d'infrastructure technique permettant d'évacuer la chaleur.

Un autre objet de la présente est d'améliorer l'efficacité énergétique d'une infrastructure technique.

Un autre objet de la présente invention est de concevoir des centres de calcul (data center) économes en énergie.

Un autre objet de la présente invention est de réduire ou limiter les consommations énergétiques des infrastructures physiques (système de gestion de l'air, système de refroidissement par exemple) d'une infrastructure technique.

Un autre objet de la présente invention est d'intégrer la dimension architecturale pour réduire la consommation énergétique d'une infrastructure technique.

Un autre objet de la présente invention est d'améliorer les performances d'une infrastructure technique et de réduire son empreinte écologique.

Un autre objet de la présente invention est de réduire les coûts relatifs au refroidissement d'une infrastructure technique.

A cette fin, l'invention se rapporte, selon un premier aspect, à une infrastructure technique de centres de données comprenant une pluralité de salles informatiques agencées en forme de cheminée dont la cavité est ouverte vers le haut, ladite infrastructure technique comprenant, en outre, une pluralité de ventilateurs aménagés dans les faces donnant dans ladite cavité, chaque ventilateur étant agencé pour ressortir l'air de l'intérieur de l'infrastructure technique vers la cavité.

Selon un mode de réalisation, chaque salle informatique de l'infrastructure technique comprend au moins un ventilateur donnant dans la cavité et au moins une ouverture donnant sur une face latérale de l'infrastructure technique.

Avantageusement, la cavité verticale résultante de la forme en cheminée de l'infrastructure technique permet d'évacuer vers l'extérieur, par effet de cheminée (tirage thermique), l'air chaud se trouvant à l'intérieur de l'infrastructure technique.

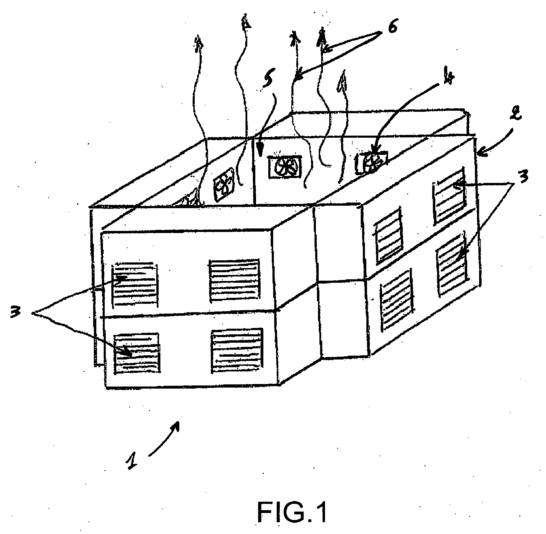

D'autres caractéristiques et avantages de l'invention apparaîtront plus clairement et de manière concrète à la lecture de la description ci-après de modes de réalisation préférés, laquelle est faite en référence à la figure 1 qui illustre schématiquement une vue en perspective d'une infrastructure technique agencée selon la présente invention.

La description ci-après est faite en référence à un data center. Cet exemple d'infrastructure technique n'est bien entendu pas limitatif et peut se rapporter à toute autre infrastructure immobilière dédiée aux technologies de l'information et de la communication.

Sur la figure 1 est représenté un data center 1 qui peut avoir plus d'une fonction tel qu'un centre de repli (ou de sauvegarde), un centre d'hébergement pour une pluralité d'entreprises, ou un centre d'interconnexion pour une pluralité d'opérateurs.

Le data center 1, composé d'une pluralité de salles (ou de blocks) 2 informatiques, est agencé en forme de cheminée. Le data center 1 .constitue ainsi un bâtiment creux ayant une cavité 5 ouverte vers le haut.

Des ventilateurs 4, aménagés dans les faces donnant dans la cavité 5 du data center 1, permettent d'acheminer l'air chaud vers la cavité 5, qui a son tour, par effet de cheminée, l'évacue vers l'extérieur. L'effet de cheminée est dû à l'écart de température entre l'air chaud à l'intérieur du data center 1 et l'air froid de l'extérieur, lequel provoque un déplacement ascendant 6 d'air en provenance des ventilateurs 4.

Avantageusement, la combinaison de l'effet de cheminée produit par la cavité 5 et de la force du vent à l'entrée des ouvertures murales 3, aménagées dans les faces latérales du data center 1, assurent une ventilation naturelle du data center 1. Autrement dit, l'air est naturellement mis en mouvement au travers des salles 2 informatiques du data center 1. En effet, l'air soufflé par les ouvertures murales 3 vers l'intérieur du data center 1 ressort, via les ventilateurs 4, par tirage thermique vers la cavité 5.

En variante, la ventilation peut être produite artificiellement par les ventilateurs 4 en jouant le rôle, dans ce cas, d'extracteurs d'air.

De préférence, la cavité 5 est polygonale convexe, notamment rectangulaire ou carrée. En variante, la cavité 5 est polygonale concave ou croisé.

De préférence, chaque salle 2 informatique comprend au moins un ventilateur 4 donnant dans la cavité 5 et au moins une ouverture 3 donnant sur une face latérale de l'infrastructure 1.

De préférence, les salles 2 informatiques (ou les blocks 2) sont sensiblement identiques. Dans un mode de réalisation, les salles 2 informatiques sont des parallélépipèdes.

L'agencement en forme de cheminée de data center qui vient d'être décrit présente un certain nombre d'avantages. Il permet en effet
- d'améliorer l'efficacité énergétique de l'infrastructure technique, en réduisant l'énergie consommée pour alimenter et refroidir, par exemple, un serveur par rapport à sa propre consommation ;
- de limiter l'impact néfaste sur l'environnement en réduisant la consommation d'énergie ;
- d'extraire naturellement, par tirage thermique (effet cheminée), l'air chaud de l'intérieur du data center ;
- d'améliorer le refroidissement de l'intérieur du data center en maitrisant le flux d'air.

## Revendications

1. Infrastructure technique (1) de centres de données, comprenant une pluralité de salles (2) informatiques agencées en forme de cheminée dont la cavité (5) est ouverte vers le haut, ladite infrastructure technique (1) étant, en outre, **caractérisée en ce qu'**elle comprend une pluralité de ventilateurs (4) aménagés dans les faces donnant dans ladite cavité (5), chaque ventilateur (4) étant agencé pour ressortir l'air de l'intérieur de l'infrastructure technique (1) vers la cavité (5).

2. Infrastructure technique (1) selon la revendication précédente, **caractérisée en ce qu'**elle comprend au moins une ouverture murale (3) agencée pour permettre l'entrée d'air vers l'intérieur de l'infrastructure technique (1).

3. Infrastructure technique (1) selon la revendication précédente, **caractérisé en ce que** chaque salle (2) comprend un ventilateur (4) donnant dans la cavité (5) et une ouverture (3) donnant sur une face latérale de l'infrastructure technique (1).

4. Infrastructure technique (1) selon l'une quelconque des revendications précédentes, **caractérisée en ce que** les salles (2) sont sensiblement identiques.

5. Infrastructure technique (1) selon l'une quelconque des revendications précédentes, **caractérisée en ce que** les salles (2) sont des parallélépipèdes.

6. Centre de données comprenant une infrastructure telle que définie dans l'une quelconques des revendications 1 à 5.

## Patentansprüche

1. Technische Infrastruktur (1) für Datenzentren, umfassend eine Vielzahl von Computerräumen (2), die in der Form eines Kamins angeordnet sind, dessen Hohlraum (5) nach oben offen ist, wobei die technische Infrastruktur (1) unter anderem **dadurch gekennzeichnet ist, dass** sie eine Vielzahl von Ventilatoren (4) umfasst, die in den Flächen vorgesehen sind, die zum Hohlraum (5) hin gehen, wobei jeder Ventilator (4) angeordnet ist, um Luft aus dem Innern der technischen Infrastruktur (1) zum Hohlraum (5) hin auszutragen.

2. Technische Infrastruktur (1) nach dem vorhergehenden Anspruch, **dadurch gekennzeichnet, dass** sie mindestens eine Maueröffnung (3) umfasst, die so ausgelegt ist, dass sie den Eintritt von Luft in das Innere der technischen Infrastruktur (1) gestattet.

3. Technische Infrastruktur (1) nach dem vorhergehenden Anspruch, **dadurch gekennzeichnet, dass** jeder Raum (2) einen Ventilator (4), der zum Hohlraum (5) hin geht, und eine Öffnung (3), die zur Seitenfläche der technischen Infrastruktur (1) hin geht, umfasst.

4. Technische Infrastruktur (1) nach einem der vorhergehenden Ansprüche, **dadurch gekennzeichnet, dass** die Räume (2) im Wesentlichen identisch sind.

5. Technische Infrastruktur (1) nach einem der vorhergehenden Ansprüche, **dadurch gekennzeichnet, dass** die Räume (2) Parallelepipede sind.

6. Datenzentrum, umfassend eine Infrastruktur nach einem der Ansprüche 1 bis 5.

## Claims

1. Technical infrastructure (1) for data centres, comprising a plurality of computer rooms (2) arranged in chimney form, the cavity of which (5) is upwardly open, said technical infrastructure (1) being further **characterized in that** it comprises a plurality of fans (4) arranged in the faces giving into said cavity (5), each fan (4) being arranged to extract the air from the interior of the technical infrastructure (1) to the cavity (5).

2. Technical infrastructure (1) according to the preceding claim, **characterized in that** it comprises at least one wall opening (3) arranged to allow the entry of air to the interior of the technical infrastructure (1).

3. Technical infrastructure (1) according to the preceding claim, **characterized in that** each room (2) comprises a fan (4) giving into the cavity (5) and an opening (3) giving onto a lateral face of the technical infrastructure (1).

4. Technical infrastructure (1) according to any one of the preceding claims, **characterized in that** the rooms (2) are substantially identical.

5. Technical infrastructure (1) according to any one of the preceding claims, **characterized in that** the rooms (2) are parallelepipeds.

6. Data centre comprising an infrastructure as defined in any one of Claims 1 to 5.
